# EUROPEAN PATENT APPLICATION

(11) **EP 0 755 077 A2**
(43) Date of publication of application: **22.01.1997**
(21) Application number: 96305130.5
(22) Date of filing: 12.07.1996
(51) Int. Cl.: H01L 29/739, H01L 29/74, H01L 29/78

(54) **High power MOS guided devices and methods of manufacturing them**

(30) Priority: 21.07.1995 GB 9514996
(71) Applicant: PLESSEY SEMICONDUCTORS LIMITED, Swindon, Wiltshire SN2 2QW (GB)
(72) Inventor: Waind, Peter Rawson, Branston, Lincoln, LN4 1PZ (GB); Sadler, David Neil, Darlington, Co. Durham, DL1 2UU (GB); Thomson, James, Lincoln, LN6 7UE (GB); Kerr, John Anthony, Forest Park, Lincoln, LN6 0XT (GB)
(74) Representative: Burrington, Alan

(57) **Abstract**

In a method of manufacturing a power transistor such as an IGBT, MOSFET or MCT the emitter of each cell is recessed and has an overlay metallisation, there being a silicide layer lining the walls of each recess and electrically interconnecting the source and body diffusions of the device.

## Description

The present invention relates to semiconductor devices and to methods of manufacturing them and more particularly to methods of manufacturing high power transistors such as IGBTs (insulated gate bipolar transistor), MOSFETs (MOS field effect transistor) or MCTs (MOS controlled thyristor).

Prior art methods of manufacturing a high power MOSFET are disclosed in US patent Nos. 4376286; 4593302; 4680853; 4642666 and 4959699. These methods involve the use of a so-called planar double diffused process.

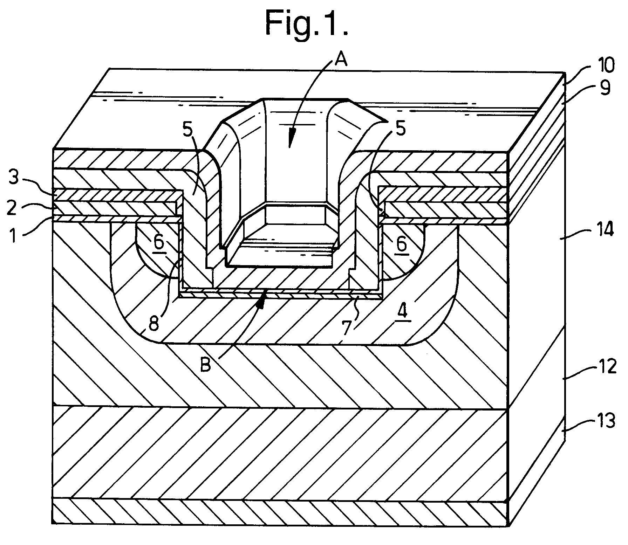

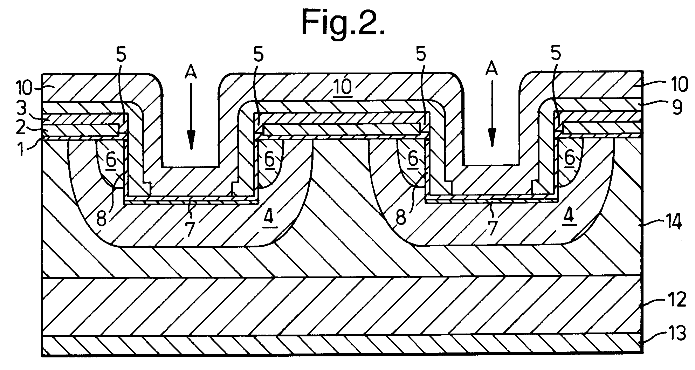

The term "Planar Double Diffused" describes the process by which the two layers of p-type and n-type (labelled 4 and 6 respectively in Figures 1 and 2 are diffused sequentially through openings in the polysilicon gate. No etching of the silicon takes place in the process described in US 4705759, so the surface remains planar.

The main disadvantages of the known planar process are;
(a) The source/emitter contact to the p-layer (4 in Figures 1 and 2) is relatively remote from the channel area of the MOSFET. This increases the likelihood of conduction by the parasitic bipolar transistor. In the case of the IGBT this may lead to latch-up, and in the case of the MOSFET to premature voltage breakdown.
(b) To control the problems discussed in (a) an additional p+ diffusion is normally used to reduce the resistive path in the p-layer between the contact and the channel region. Also an opening must be left in the n-layer to allow contact to be made directly to this p-layer. These features require additional processing, in particular extra photolithography within the source/emitter opening which makes reduction of feature size difficult.

These problems have been addressed in European application 0 091 686 which discloses a process for manufacturing a semiconductor device having a recessed emitter structure in order to overcome the problem of incipient current conduction in a parasitic bipolar transistor inherent in the device thus causing unwanted turn-on of the parasitic transistor which in turn can lead to total loss of control of current in the semiconductor device as a whole and in fact may even cause destruction of the device. However, the process disclosed in that European application has drawbacks which reduce its practicality.

The present invention is concerned with providing a structure and process of manufacturing a power semiconductor which will overcome the above discussed problems. The present invention is applicable to, for example, an IGBT, a power MOSFET, an MCT or an EST (emitter switched thyristor) although it could be applied to other types of device which have a MOSFET content.

According to the present invention a power transistor has a recessed emitter structure in combination with an overlay metallisation. In the process of the present invention there is a conductive strap connecting to the sidewalls of the recess. This can be achieved by a silicide or similar layer. According to one aspect of the present invention to reliably achieve the overlay structure use is made of an additional insulation layer which covers the gate and recess sidewalls. Without the silicide or similar layer there would be no connection between emitter metal and diffusion. It is this use of the silicide, or similar layer, the aforesaid additional insulation layer and the aforesaid emitter metal that characterises the present invention.

How the invention may be carried out will now be described by way of example only and with reference to the accompanying drawings in which:
Figure 1 is a sectional/perspective view showing a single active cell of an insulated gate bipolar transistor (IGBT) produced by the process according to the present invention;
Figure 2 is a cross-sectional view showing two adjacent active cells having substantially the same construction as the cell shown in Figure 1 to illustrate the repeated cell nature of the device;
Figure 3 is a cross-sectional view showing the starting materials for the manufacturing process;
Figures 4 to 16 show the process steps involved in manufacturing the IGBT shown in Figures 1 and 2;
Figure 17 shows the final stage in the manufacture of an IGBT or a MOSFET; and
Figure 18 is a view similar to Figure 17 but showing the final process step in the manufacture of an MCT device according to the present invention.

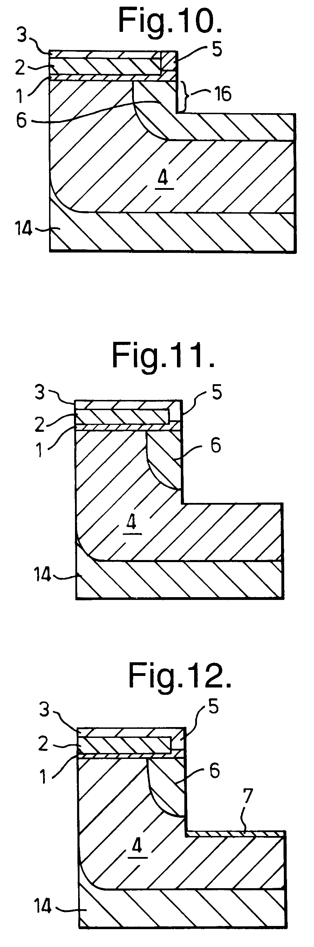

All the Figures 10 to 18 are cross-sectional views of in effect one half of an active cell of the power transistor device.

The active area of the IGBT device shown in Figures 1 and 2 consists of an array of emitter cell cut through windows in a polysilicon gate area. The active area of the Power Device is that portion responsible for controlling the current flow. This consists of an array of small cells (usually numbering several thousand) all acting in parallel to give a required total current handling capability. Figure 1 shows a section through one such cell, and Figure 2 a cross section through two adjacent cells. Each cell is made up of an emitter region (A) surrounded by polysilicon gate areas. In the on-state current flows from the emitter to the collector (13) located on the back side of the wafer. The following description relates to this active portion of the device, the other areas of the device concerned with high voltage junction termination and connection to the gate are not described or shown.

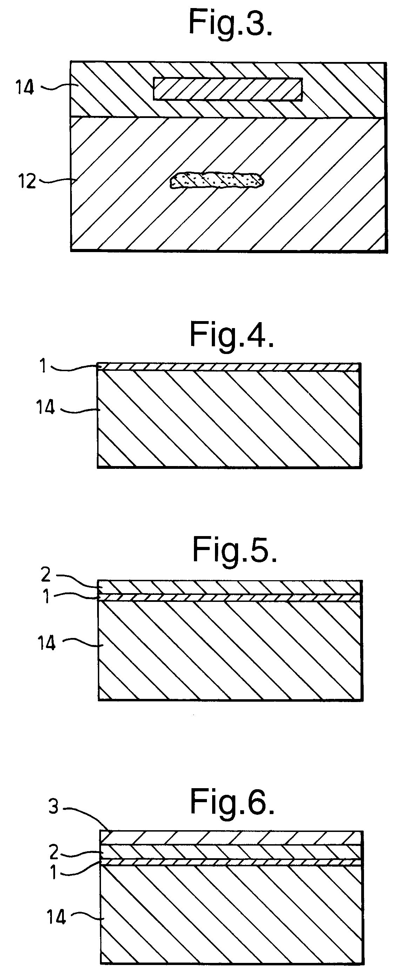

The completed IGBT will now be described with reference to Figures 1 and 2 and then the process for manufacturing it will be described with reference to Figures 3 to 17.

### Figures 1 and 2

The IGBT has a substrate 12 of bulk silicon and an epitaxial silicon layer 14. The silicon substrate 12 is provided with a metal electric contact layer 13 which acts as the collector for the IGBT and would act as the drain in the case of the invention being applied to a MOSFET.

The thickness of the epitaxial layer 14 depends upon the voltage drop required. In this embodiment the epitaxial layer 14 is n type and the bulk silicon 12 is p type.

The emitter of the cell is recessed at A and is formed by aluminium metallisation layer 10.

The gate of the IGBT cell is formed by gate oxide layer 1 and gate conductor layer 2.

The source of the IGBT comprises the diffusion area 6 which is electrically connected to the base of the recess A by a silicide layer 8.

There is an implant/diffusion 4 formed in the epitaxial silicon layer 14.

There is an insulating layer 9 between the aluminium metallisation 10 and the masking layer 3.

There is a passivating layer 5 which should be considered to be distinct from layer 3 as these two layers are formed at different stages in the overall process.

The layer diagrammatically indicated at 7 is a second dose of the implant 4. The essence of the construction according to the present invention is the combination of the recessed emitter structure, the silicide layer 8 and the overlay metallisation 10.

The silicide layer 8, as indicated earlier, makes good electrical contact between the source diffusion area 6 and the body diffusion area 4 along the base and side walls of the recess A. A deposited insulating layer 9 is used to coat the gate areas in the recess side walls to allow aluminium metallisation 10 to overlay the gate and make contact with the base of each emitter cell. This metal layer need only make contact at the centre of each cell as the silicide layer 8 is relied upon to distribute current beneath the insulating layer 9 to the source regions 6.

With the exception of the contact window B formed in the insulating layer 9, the diffusions of each cell and the silicide strap are produced by self aligned techniques.

The advantage of this construction is that small emitter windows may be reliably fabricated without the need for very accurate photolithographic registration of the layers.

The process for manufacturing the IGBT shown in Figures 1 and 2 will now be described with reference to Figures 3 to 17.

### Figures 3 to 17

Referring to Figure 3, a bulk silicon substrate 12 has an epitaxial silicon layer 14 formed on it. The thickness, and resistivity, of this epitaxial layer depends on the desired reverse voltage required. This layer 14 may be high resistance epitaxially grown Si on top of a single crystal silicon of the opposite type 12. Alternatively it could comprise an homogeneous high resistivity wafer 14 with layer 12 produced by doping with the opposite type by conventional processes at some stage during the processing.

In the case of a MOSFET layers 14 and 12 are of the same type and in the case of IGBT layers 14 and 12 are of opposite type.

In this embodiment the substrate 12 is p type and the epitaxial layer 14 is n type.

In Figures 4 to 17 only a portion of the upper surface of the device is shown. The process steps required to manufacture the active regions will now be described.

The first step is to grow a gate oxide 1 on the exposed epitaxial silicon surface 14. This oxide layer could typically be 400 to 2,000 Å thick, this step being shown in Figure 4.

The next step is shown in Figure 5 and comprises the deposition, by standard semiconductor techniques, of a conductive polysilicon layer 2 which will form the gate of the device.

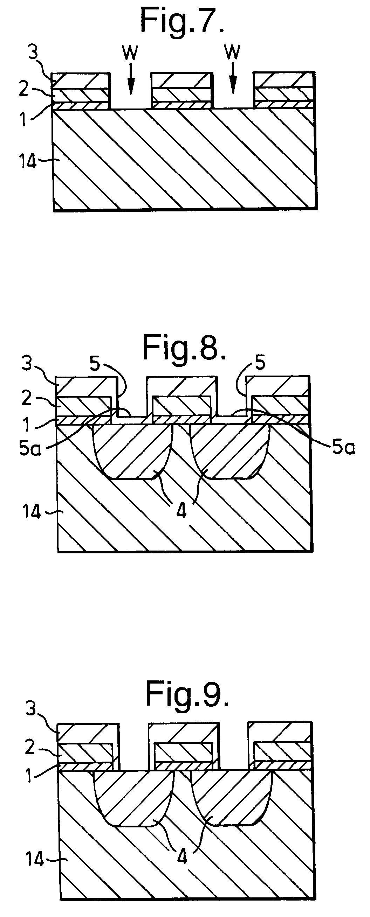

The next step, shown in Figure 6, consists in providing a masking layer 3 which could be an oxide and which could be thermally grown or deposited on top of the polysilicon gate layer 2. The layer 3 must be thick enough to act as a mask during subsequent diffusion, implant and etching processes.

The next step is shown in Figure 7 where windows W are etched in the multi-layer 1, 2, 3, down to the substrate 14, using standard photolithographic and etching techniques. The array of cells thus formed could typically be 5 to 30 µm wide with similar spacing between the cells. These cells are produced over the active area of the device.

The next stage in the process is shown in Figure 8 and this consists of an implant/diffusion step. Firstly an implant/diffusion 4 is carried out, this being of opposite type to the substrate 14, typically 2E14. The implant/diffusion takes place through the windows W which have previously been formed. The depth of the implant/diffusion 4 could typically be 2-6 µm.

During this process the upper oxide layer 3 acts as a mask and defines the extent of the diffusion under the mask edge.

During the diffusion of the previous implant the sidewalls are passivated by the formation of oxide layer 5 in order to fully insulate the gate polysilicon.

As an alternative, the layer 5 may be generated by well known deposition and etch techniques.

The next stage, shown in Figure 9, is to remove the passivation layer 5a (see Figure 8) which has formed on the base of the windows W. This is achieved by means of an anisotropic plasma etch which though removing the passivation layer at the base of the windows W leaves the passivation layers in the side walls of those windows intact. In other words the etch only eats downwardly, and not sideways, as viewed in Figures 8 and 9.

The next stage is shown in Figure 10 which is an enlarged fragmentary view of the arrangement shown in Figure 9, the dimensions being exaggerated in order to facilitate an understanding of the process. A highly selective anisotropic silicon plasma etch results in a recess 16 shown in Figure 10. The recesses 16 are formed below the level of the gate oxide 1 and the walls of these recesses should ideally be vertical. Again the upper oxide layer forms a mask defining and aligning the recess to the diffusions.

There follows a further diffusion 6, through the windows W, of the opposite type to diffusion 4. The diffusion 6 is into the side and bottom of the recess or window W and is of sufficient surface concentration to allow the formation of a low resistance electrical contact on the side wall and with sufficient depth to form the source of the MOSFET beneath the gate oxide 1. The depth of the diffusion 6 must not exceed that of the diffusion 4 and can be as shallow as 0.5 µm or less into the side walls of the recess or window. This thus eliminates unwanted parasitic effects such as latch-up in the case of the IGBT.

In order to remove that part of the second diffusion 6 which lies at the base of the window W a further anisotropic etch is carried out in order to produce the structure shown in Figure 11. It is important that this etch should not exceed the depth of the first diffusion 4.

Figure 12 illustrates the next step in the process in which an implant 7, of the same type as diffusion 4, is carried out to form the area shown at the base of the window W. The side wall of the window recess is not significantly affected by this process as its walls are vertical and the implant is from the vertical. Again the upper oxide layer 3 forms a mask during this step.

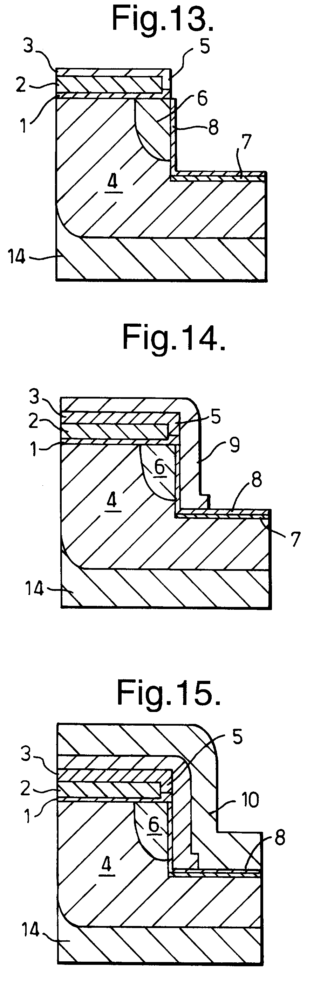

The next step is shown in Figure 13 in which a self-aligned metal silicide layer 8 is then formed in the window or recess W using standard semiconductor techniques. Further information on the self-aligned silicide process is disclosed in C.M. Osburn; Q.F. Wang; M. Kellan; C. Canovai; P.L. Smith; G.E. McGuire; Z.G. Xiao; G.A. Rozonyi. "Incorporation of Metal Silicides and Refractory Metals in VLSI Technology". Applied Surface Science 53(1991) p291-312. Proceedings of the 4th European Workshop on Refractory Metals and Silicides 1991.

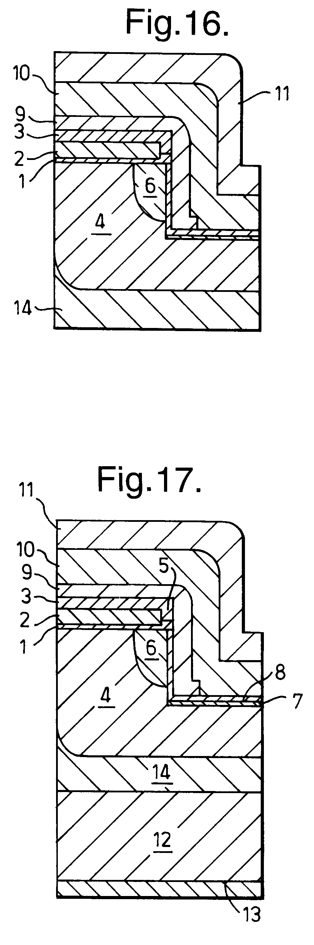

The metal silicide 8, which is formed not only on the base but on the side walls of the recess or window W, electrically connects together the diffusions 4 and 6, the layer 8 being of relatively low electrical resistance, typically 13-15mΩ-cm. The effective short circuit between the regions 4 and 6 eliminates parasitic effects such as latch-up in the case of the IGBT, or lower breakdown voltage in the case where the invention is used to manufacture a MOSFET (see Figure 17 and corresponding description).

Figure 14 illustrates the next step in the process which is to provide an insulating layer 9 to protect the polysilicon gate 2 from the subsequent metal deposition.

The insulating oxide 9 would initially also cover the base of the recess/window W but this base covering is then removed using normal photolithographic and etching techniques. It should be noted that this is the only lithographic stage carried out within the recess/windows W, all the other steps within this area employing self-aligning techniques. The advantage of this is that it allows the cell openings W to be reduced in size to about 5 µm to thus optimize the device's performance.

As indicated immediately above, the next step in the process, illustrated in Figure 15, is to provide a metal deposition 10 over all areas. The metal may typically be aluminium. A pattern is defined in the metal layer 10 by normal photolithographic and etching techniques so that the emitter areas, or cells, are interconnected by a metal layer or plate that covers the whole active area.

In this way all the emitter cells are electrically connected in parallel by connection to the silicide layer 8. The aluminium of the metal layer 10 is not required to contact the recess/window W walls as current is distributed by the silicide layer 8 to diffusions 6 and 4. The gate area 1, 2 is insulated by the oxide layer 9.

A passivating layer or layers 11 is/are then deposited covering all areas, including the recess/window side walls, as shown in Figure 16. It should be noted that the layer 11 is not shown in Figures 1 and 2.

Contact windows are opened to the gate and source pad areas using normal photolithographic and etching techniques.

Finally, metal layers 13 are deposited onto the underside of the silicon substrate 12 to ensure good electrical contact, as shown in Figure 17. In the case of an IGBT the layer 13 will form the collector of the device and in the case of a MOSFET the layer 13 will form the drain.

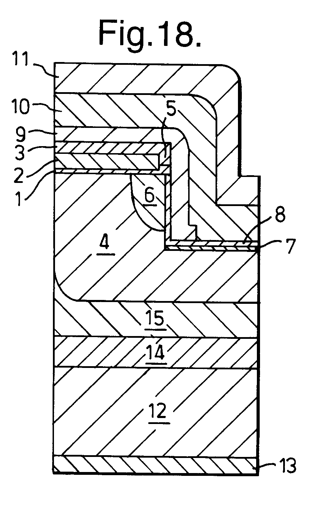

The present invention may also be used to manufacture an MCT device, as indicated earlier, in which case an extra diffusion layer 15 would be included, as shown in Figure 18, this diffusion layer being of the same type as the diffusion layer 4.

One advantage of the process of the present invention is that because self-aligning techniques are used smaller emitter windows may be reliably fabricated without the need for the use of highly accurate photolithographic methods.

## Claims

1. A power transistor having a recessed emitter structure in combination with an overlay metallisation.

2. A power transistor as claimed in claim 1 having a silicide layer contacting and electrically interconnecting the walls and base of each recess.

3. A power transistor as claimed in claim 2 in which the gate and recess side walls are insulated with a deposited oxide and the overlay metallisation electrically connects to the silicide layer via apertures formed in the oxide in the base of the recess so that in use the emitter current is distributed to the source and body diffusions under the oxide layer by the silicide layer.

4. A power transistor as claimed in any previous claim comprising an insulated gate bipolar transistor (IGBT).

5. A power transistor as claimed in any one of claims 1 to 3 comprising a power MOSFET.

6. A power transistor as claimed in any one of claims 1 to 3 comprising an MOS controlled thyristor.

7. In a method of manufacturing a power transistor, there is formed a recessed emitter structure in combination with an overlay metallisation.

8. In a method as claimed in claim 7 there is formed a silicide layer contacting and electrically interconnecting the walls and base of each recess.

9. In a method as claimed in claim 8 there is formed deposited oxide which insulates the gate and recess side walls and apertures are formed in the oxide in the base of the recess so that the overlay metallisation electrically connects to the silicide layer so that in use the emitter current is distributed to the source and body diffusions under the oxide layer by the silicide layer.

10. An insulated gate bipolar transistor (IGBT) manufactured by the method as claimed in any one of claims 7 to 9.

11. A power MOSFET manufactured by the method as claimed in any one of claims 7 to 9.

12. An MOS controlled thyristor manufactured by the method as claimed in any one of claims 7 to 9.

13. An insulated gate bipolar transistor (IGBT) substantially as hereinbefore described with reference to and as shown in the accompanying drawings.

14. A power MOSFET substantially as hereinbefore described with reference to and as shown in the accompanying drawings.

15. An MOS controlled thyristor substantially as hereinbefore described with reference to and as shown in the accompanying drawings.

16. A method of manufacturing an insulated gate bipolar transistor (IGBT) substantially as hereinbefore described with reference to the accompanying drawings.

17. A method of manufacturing a power MOSFET substantially as hereinbefore described with reference to the accompanying drawings.

18. A method of manufacturing an MOS controlled thyristor substantially as hereinbefore described with reference to the accompanying drawings.
